# EUROPEAN PATENT SPECIFICATION

(11) **EP 3 227 921 B1**
(45) Date of publication and mention of the grant of the patent: **24.07.2019**
(21) Application number: 15864803.0
(22) Date of filing: 03.12.2015
(51) Int. Cl.: H01L 27/146

(54) **PIXEL STRUCTURE FOR ENERGY HARVESTING AND IMAGE SENSING**
PIXELSTRUKTUR ZUR ENERGIEGEWINNUNG UND BILDERFASSUNG
STRUCTURE DE PIXEL POUR COLLECTE D'ÉNERGIE ET DÉTECTION D'IMAGE

(30) Priority: 03.12.2014 US 201462086733 P; 03.12.2014 US 201462086737 P
(43) Date of publication of application: 11.10.2017
(73) Proprietor: Robert Bosch GmbH, 70442 Stuttgart (DE)
(72) Inventor: SHAH, Nishit, Stanford, CA 94305 (US); LAJEVARDI, Pedram, Menlo Park, CA 94025 (US); LANG, Christoph, Sunnyvale, CA 94087 (US)
(86) International application number: PCT/US2015/063726
(87) International publication number: WO 2016/090135

(56) References cited:
- CN-A- 104 157 658
- KR-A- 20100 080 173
- US-A1- 2010 270 459
- US-A1- 2012 050 598
- US-A1- 2012 286 141
- US-A1- 2013 020 465
- US-A1- 2014 217 474

## Description

### CLAIM OF PRIORITY

This application claims priority to U.S. Provisional Application No. 62/086,737, which is entitled "Pixel Structure for Energy Harvesting and Image Sensing," and was filed on December 3, 2014. This application also claims priority to U.S. Provisional Application No. 62/086,733, which is entitled "Pixel Structure for Energy Harvesting and Image Sensing," and was filed on December 3, 2014.

### FIELD

This disclosure relates generally to the field of photoelectric devices and, more specifically, to semiconductor devices that are configured for both image generation and generation of electricity in response to being exposed to light.

### BACKGROUND

Semiconductors in general, and complementary silicon metal oxide (CMOS) semiconductors in particular, are used in a wide range of applications including use as image sensors in digital cameras and as photovoltaic devices that generate electricity from sun light and other light sources. Some cameras, such as battery-powered surveillance cameras, have high energy consumption and may have a limited battery life. Some existing cameras incorporate separate photovoltaic devices that generate energy from sunlight or other light sources while also using a CMOS sensor as an image detector. However, these cameras required two different types of semiconductor devices that increase the cost, complexity, and size of the cameras.

Recent teachings in the art suggest energy collector CMOS sensors that have two different operating modes or CMOS sensors that include a fixed array of sensing elements and photovoltaic energy collection elements. In the sensor embodiments that include two different operating modes, a CMOS imaging chip switches between operating modes where all of the elements in the sensor operate as either image sensing elements or as an energy harvesting elements. The imaging device is switched between the imaging and energy collection modes at different times. While the CMOS sensor has lower efficiency at harvesting solar energy than a dedicated solar cell, the advantage of this approach is to use the CMOS sensor as an energy harvesting element in the camera when the camera is not being used to generate images. In the fixed-array sensors, some of the elements in the CMOS sensor detect light and generate electrical signals to produce a digital image from the detected light, while other elements in the CMOS sensor are photovoltaic elements generate energy from incident light that strikes the CMOS sensor.

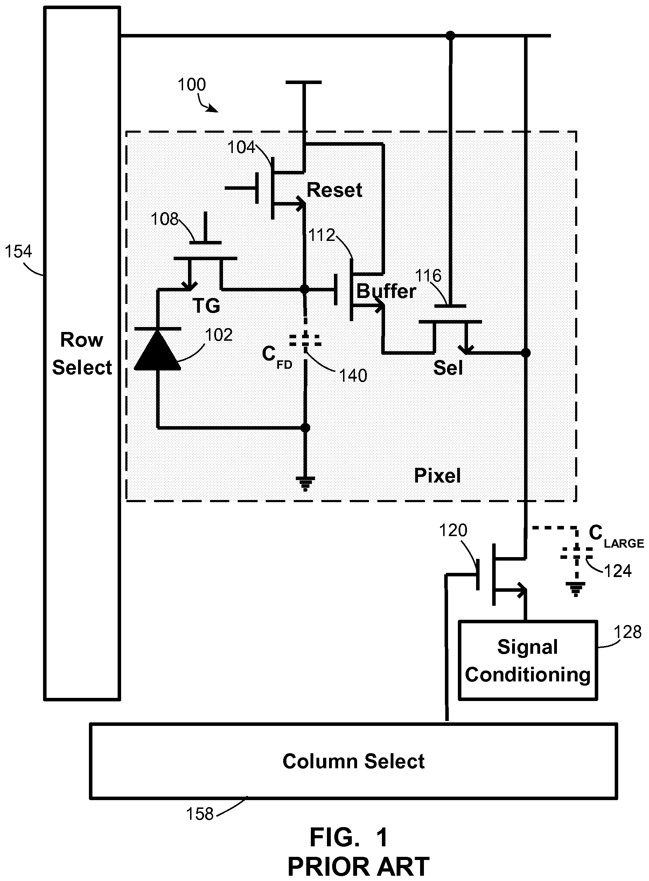

FIG. 1 depicts a prior art four-transistor image sensing element 100. The image sensing element 100 is also referred to as a "pixel", and a CMOS image sensor typically contains a large array (e.g. thousands or millions) of the sensor elements 100 arranged in a two-dimensional grid including a plurality of rows and columns. While FIG. 1 depicts a four-transistor image sensing element 100, three-transistor elements are also known to the art. The four-transistor element is described herein due to the improved linearity and noise-reset characteristics of four-transistor elements and for applications where a conversion gain of the pixel (inversely proportional to photodiode capacitance) needs to be decoupled from the dynamic range (directly proportional to photodiode capacitance) specification.

The sensing element 100 includes a photo-diode 102, reset transistor 104, transfer gate transistor (TG) 108, buffer transistor 112, row select transistor (SEL) 116, and a sensor capacitor C_{FD} 140. The sensing element 100 is connected to other elements in a larger CMOS image sensing device including row select logic 154, column select logic 158, a bit line select transistor 120, bit line capacitor (C_{LARGE}) 124, and signal conditioning circuitry 128. In the element 100 of FIG. 1, the photodiode 102 generates an electrical signal when exposed to light based on the photoelectric effect. The photodiode 102 includes an anode that is connected to the capacitor 140 and to ground, and a cathode that is connected to the source of the transfer gate transistor 102.

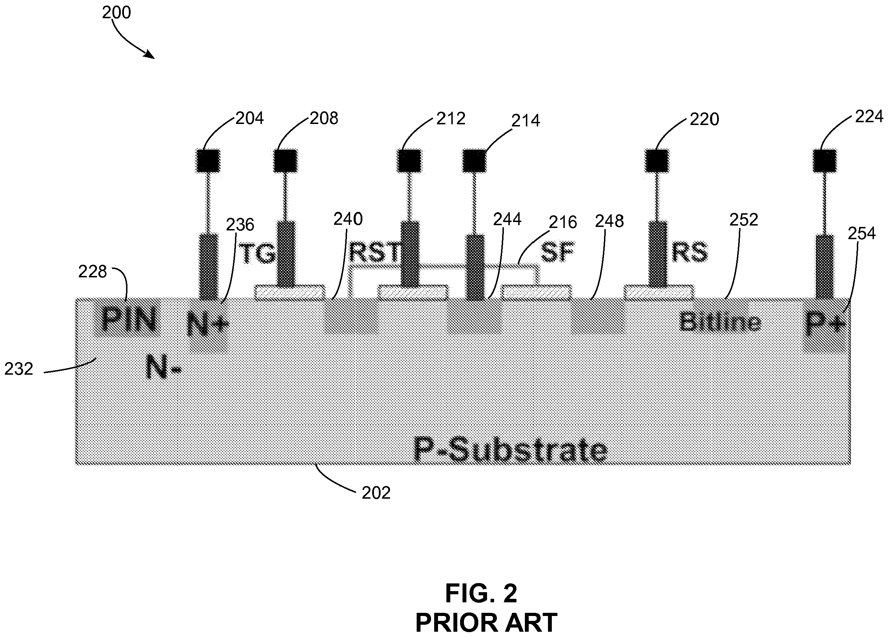

FIG. 2 depicts a cross-sectional view of a semiconductor sensor element embodiment 200 that implements the prior art sensor element 100 of FIG. 1 in a monolithic semiconductor substrate. The sensor element 200 is formed from a P-type substrate 202 that includes a PIN region 228 from the photodiode 102, a lightly doped N- region 232, heavily doped N-regions 236, 240, 244, 248, and 252, and heavily doped P+ region 254. The existing 4T-pixel has PIN layer that is connected to the P-substrate in die. This layer helps reduce the surface roughness and hence dark current. The PIN layer also improves blue light absorption. However, this PIN layer being connected to the P type substrate "pins" or fixes the potential of the PIN layer to that of the substrate. When used as energy harvester, this photodiode always generates voltage with respect to P-Substrate (usually ground) of the IC. The various P and N type regions and transistor elements are formed using doping and lithographic techniques that are known to the art. The sensor element 200 is formed with the P-type, N-type, and gate structure regions that implement the photodiode 102, and the transistors 104, 108, 112, and 116. In particular, the transfer gate transistor 108 is formed from a source region 236 connected to the cathode 204 of the photodiode 102, a gate 208, and a drain region 240 that also forms the source of the reset transistor 104 and is connected to the gate 216 of the buffer transistor 112. The reset transistor 104 also includes the gate 212 and a drain region 244 that also forms the drain of the buffer transistor 112. The region 244 is connected to an external reset line 214 that receives a reset signal to clear the capacitor 140 and reset other components in the element 100 after generating a pixel of image data during an imaging operation. The buffer transistor 112 also includes a source region 248 that also forms the drain of the row select transistor 116. The row select transistor 116 also includes a gate 220 and a source region (Bitline) 252. The P+ region 254 is connected to the substrate of the element 100 that is connected to the bit line select transistor 120 in the embodiment of FIG. 1.

The existing structure of the semiconductor CMOS sensor elements makes operation of the CMOS imaging device in two different modes difficult. Existing CMOS image sensor elements are designed to generate an electrical signal when light strikes a photo-diode. Photovoltaic devices, however, are configured to generate an electrical power signal when light strikes a photo detector. The existing CMOS sensors that incorporate both CMOS image sensor elements and photovoltaic elements have drawbacks because the size of the CMOS image sensor increases greatly to accommodate the imaging and energy collection elements in a single device. Many cameras can only accommodate CMOS sensors of a limited size, which makes a CMOS device that includes separate imaging and energy collection elements impractical. CMOS sensors that switch between energy harvesting and imaging modes also have drawbacks since the camera cannot generate images while the CMOS sensor operates in an energy collection mode, and cannot collect energy when the CMOS sensor generates images. Consequently, improvements to the design of elements in a CMOS sensor that enable efficient operation in both image sensing and energy collection operating modes would be beneficial.
The following documents disclose further technological background information for the present invention:
- D1: CN 104 157 658 A (SUZHOU ORIENTAL SEMICONDUCTOR CO LTD) 19 November 2014 (2014-11-19); & US 2017/084648 A1 (LIU WEI [CN] ET AL) 23 March 2017 (2017-03-23)
- D2: US 2014/217474 A1 (LEE JUN-TAEK [KR] ET AL) 7 August 2014 (2014-08-07)
Document D1 discloses a pixel of a CMOS device in which, similarly in the prior art FIG. 1, a photodiode is connected to the CMOS transistors. In document D2 a photodiode is permanently connected to ground.
The object of the present invention is to provide a pixel and a camera which can efficiently be used for energy harvesting as well as image sensing. This object is solved by claim 1 and by claim 7 and further advantageous embodiments are claimed in the dependent claims. Aspects of the present invention which contribute to the understanding of the invention are listed below.

### SUMMARY

A semiconductor sensor and energy collector device includes semiconductor structures that act as an energy harvester or as an image sensing pixel with neither of the terminals connected to a fixed voltage supply. The semiconductor device includes a PIN layer and two terminals where neither terminal is connected to a fixed voltage supply. The PIN layer is disconnected from the P-type substrate using an N-doped isolation region. Also, a separate connection to both PIN layer and N- doped region formed in the sensor acts as the positive terminal (POS) and negative terminal (NEG) of the energy harvester respectively.

In one aspect, a pixel in a complementary metal oxide semiconductor (CMOS) sensor that is reconfigurable to detect light as part of an image sensor and to generate electrical power as a photovoltaic device has been developed. The pixel includes a substrate, a first N-type region formed in the substrate, at least a portion of a photodiode formed in a portion of the substrate surrounded by the N-type region and isolated from a portion of the substrate outside the N-type region, a second N-type region formed in the portion of the substrate surrounded by the first N-type region, a first doping level of the first N-type region being less than a second doping level of the second N-type region, a first output terminal connected to the second N-type region, a first P-type region formed in the portion of the substrate surrounded by the N-type region, a second output terminal connected to the first P-type region and a first transistor formed in the substrate with a source connected to the first N-type region, a gate, and a drain. The pixel is configured to detect light striking the photodiode in response to the first terminal being connected to a high-impedance, the second terminal being connected to a ground and the first transistor being activated and generate an electrical current to drive a load through the first terminal and second terminal in response to light striking the photodiode, a connection of the load being to the first terminal and the second terminal, and deactivation of the first transistor.

In another aspect, a camera including a CMOS sensor that is reconfigurable to detect light as part of an image sensor and to generate electrical power as a photovoltaic device has been developed. The camera includes a complementary metal oxide semiconductor (CMOS) device including a plurality of pixels, a battery operatively connected to the CMOS device, and a controller operatively connected to the CMOS device. The controller is configured to operate a first portion of the plurality of pixels in a first operating mode to generate an electrical current to charge the battery and operate a second portion of the plurality of pixels in a second operating mode to generate image data corresponding to light that strikes the CMOS device simultaneously to operation of the first portion of the plurality of pixels in the first operating mode.

### BRIEF DESCRIPTION OF THE DRAWINGS

FIG. 1 is a schematic diagram of a prior art four-transistor pixel that is used in a CMOS image sensor.
FIG. 2 is a cross-sectional view of a semiconductor substrate that forms the elements of the prior art four-transistor pixel of FIG. 1.
FIG. 3 is a schematic diagram of a four-transistor pixel that is reconfigurable to operate as either an imaging element or as a photovoltaic energy collector element.
FIG. 4 is a cross-sectional view of a semiconductor substrate that forms the elements of the pixel of FIG. 3.
FIG. 5 is a schematic diagram of the circuit of FIG. 3 while operating as an image sensing element.
FIG. 6 is a schematic diagram of the circuit of FIG. 3 while operating as a photovoltaic energy collector element.
FIG. 7 is a set of schematic diagrams depicting different arrangements of multiple photovoltaic energy generation elements in series, series and parallel, and parallel configurations in a CMOS sensor.
FIG. 8 is a diagram of a camera that uses a CMOS sensor with an array of pixels having the structure depicted in FIG. 3 and FIG. 4 to generate image data and collect energy in different operating modes.
FIG. 9 is a cross-sectional view of another embodiment of a semiconductor substrate that forms the elements of the pixel of FIG. 3.

### DETAILED DESCRIPTION

For the purposes of promoting an understanding of the principles of the embodiments disclosed herein, reference is now be made to the drawings and descriptions in the following written specification. No limitation to the scope of the subject matter is intended by the references. The present disclosure also includes any alterations and modifications to the illustrated embodiments and includes further applications of the principles of the disclosed embodiments as would normally occur to one skilled in the art to which this disclosure pertains.

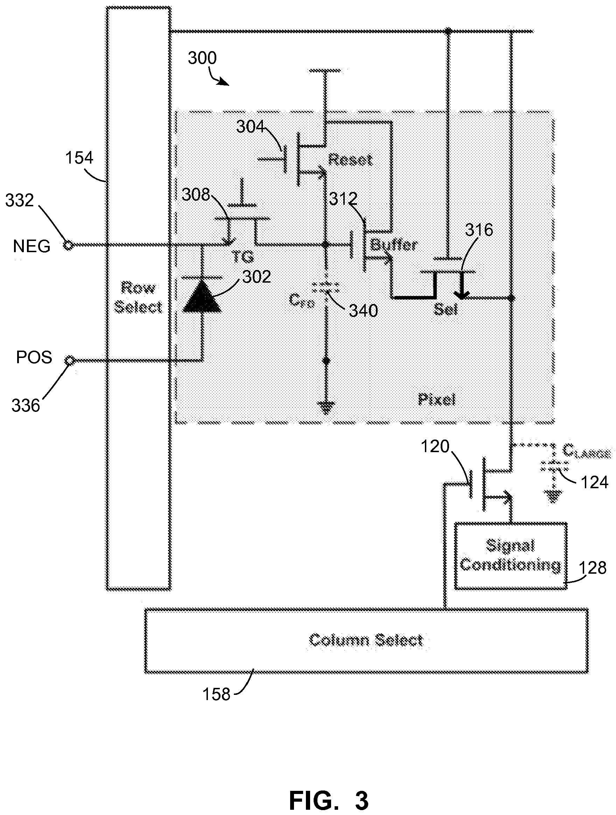

FIG. 3 depicts a pixel circuit 300 that is configurable to operate both as an imaging pixel in a CMOS image sensor and as a photovoltaic energy collector in two different operating modes. The circuit 300 includes a photodiode 302, reset transistor 304, transfer gate transistor 308, buffer transistor 312, and row select transistor 316. The pixel 300 is connected to other elements in a larger array of CMOS pixels that are included in a single CMOS device including the row select logic 154, column select logic 158, bit line select transistor 120, bit line capacitor 124, and signal conditioning circuitry 128.

In the pixel 300, the photodiode 302, reset transistor 304, transfer gate transistor 308, buffer transistor 312, and row select transistor 316 are similar to the corresponding elements depicted in FIG. 1. However, in the configuration of FIG. 3, the anode of the photodiode 302 is not connected to the capacitor 340. Instead, the cathode of the photodiode 302 is connected to a first output terminal (NEG) 332 and the anode of the cathode 302 is connected to a second output terminal (POS) 336. As described in more detail below, the terminals 332 and 336 are reconfigured to enable the pixel element 300 to operate in both image sensing modes and photovoltaic energy collection modes.

In the circuit 300, the NEG terminal 332 and the POS terminal 336 can be connected to different outputs for energy collection and image sensing operating modes using solid-state switching circuitry that is integrated into the CMOS substrate. In the energy harvesting mode, the POS and NEG terminals act like two terminals of the battery charger and can deliver energy to recharge a battery or charge a capacitor. It can also be used to deliver energy to the load directly.

As the POS and NEG terminals are not fixed to any voltage potential, these terminals can be configured in several different ways. Different photodiodes can be arranged in series, in parallel or a combination of both. Arranging photodiodes in series increases the output voltage, while arranging them in parallel increases their output current.

To deliver energy at certain fixed output voltage, the energy collector converts the energy from one voltage level to another. The output voltage and output impedance of the photodiode array changes depending on the intensity of incident light. This keeps efficiency of the energy harvester varying according to incident light. With the flexibility of arrangement of photodiode configurations, the output impedance of these photodiode arrays is changed for different voltage and current levels.

The reconfiguring capability of the photodiode array also helps maintain high efficiency at variable load current. For example, to deliver higher load currents, the impedance of the photodiode array need to be low. This can be achieved by arranging the photodiodes of the array in parallel. The higher efficiency of the energy harvester leads to lower energy losses thereby reducing the recharging time of the battery or the capacitor.

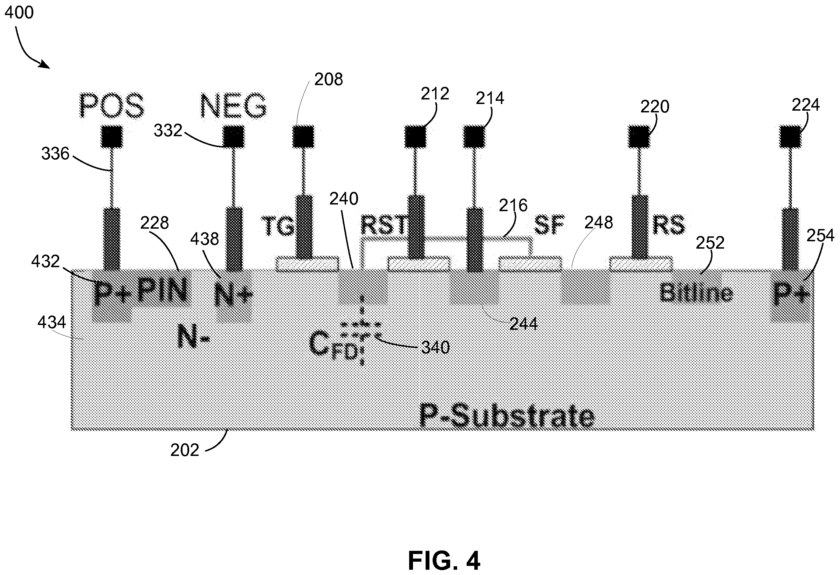

FIG. 4 depicts a cross-sectional view of a semiconductor sensor element 400 that implements the pixel 300 of FIG. 3 in a monolithic semiconductor substrate. The semiconductor embodiment 400 includes a p-substrate 202, PIN region 228, N-type heavily doped (N+) doped regions 240, 244, 248, and 252, P-type heavily doped (P+) region 254 and gate connectors 208, 212, 216, and 220 that are similar to the corresponding structures in the prior art embodiment of FIG. 2.

The sensor element 400 further incorporates an N- doped region 434, a P+ region 432 that is connected to the POS terminal 336, and an N+ region 438 that is connected to the NEG terminal 332. The N-type lightly doped (N-) region 434 surrounds the P+ region 432, PIN region 228, and the N+ region 438. The N- doped region 434 isolates the PIN region 228 from the P-substrate 202. In particular, the N- doped region 434 isolates the anode of the photodiode 302 from the capacitor 340, while the region 240 that includes the drain of the transfer gate transistor 308 and source of the reset transistor 304 remain connected to the capacitor 340.

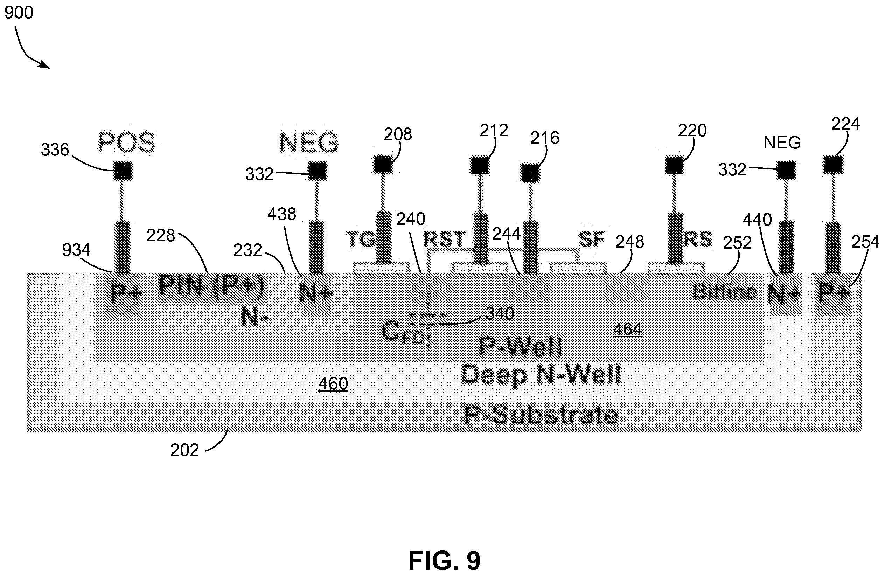

FIG. 9 depicts a cross-sectional view of another embodiment of a semiconductor sensor element 900 that implements the pixel 300 of FIG. 3 in a monolithic semiconductor substrate. The semiconductor embodiment 900 includes a p-substrate 202, PIN region 228, N-type lightly doped (N-) region 232, N-type heavily doped (N+) regions 240, 244, 248, and 252, P-type heavily doped (P+) region 254 and gate connectors 208, 212, 216, and 220 that are similar to the corresponding structures in the prior art embodiment of FIG. 2.

The sensor element 900 further incorporates a deep N-type well 460, P-well 464, a P+ contact region 934 that is connected to the POS terminal 336, and a N+ region 438 that is connected to the NEG terminal 332. The N+ region 438 is surrounded by the N- region 232 in the embodiment of FIG. 4. The deep N-type well 460 is formed above the P-substrate 202 and incorporates the N+ region 440. The sensor element 400 also includes the P-well 464 that is arranged in the substrate within the deep N-type well 460. The P-well 464 is formed around the P+ region 934, PIN region 228, N- region 232, and N+ regions 240, 244, 248, and 252. The deep N-well 460 isolates the P-well 464 from the P-substrate 202. In particular, the deep-N well isolates the anode of the photodiode 302 from the capacitor 340, while the region 240 that includes the drain of the transfer gate transistor 308 and source of the reset transistor 304 remain connected to the capacitor 340.

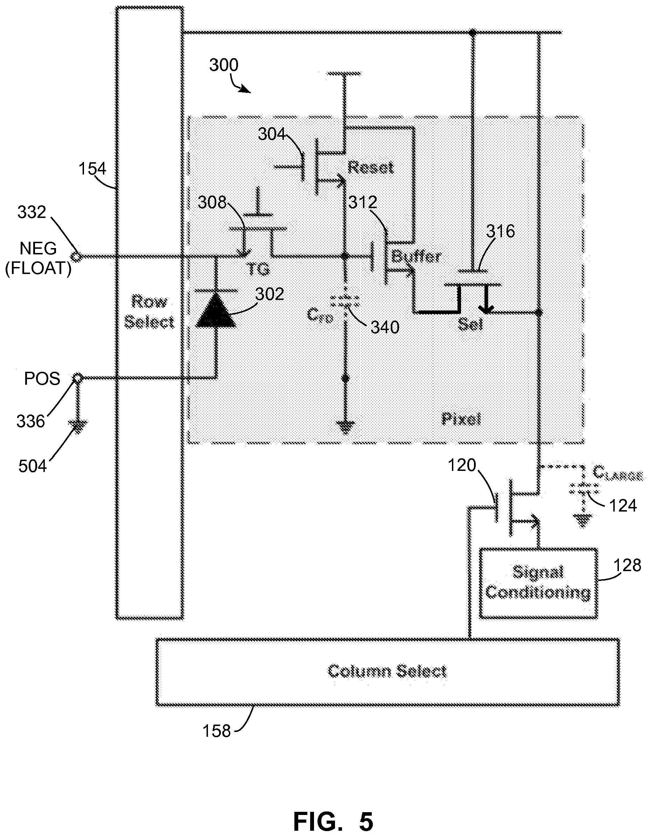

FIG. 5 depicts a configuration of the circuit 300 of FIG. 3 when the circuit 300 is configured to operate as an imaging pixel in a CMOS image sensor. In the configuration of FIG. 5, the negative terminal 332 is placed in a high-impedance ("float") configuration and the positive terminal 336 is connected to ground 504 to enable the output current from the photodiode 302 to flow to the source of the transfer gate transistor 308. In the configuration of FIG. 5, the output of the photodiode 302 remains within the pixel circuit 300 to charge the capacitor 340. During operation, an external controller (not shown) selects the pixel 300 using the row select logic 154 and column select logic 158 to charge the bit line capacitor 124 for an amount of time that is based on the rate at which the photodiode 302 charges the capacitor 340 to activate the buffer transistor 312. The signal conditioning circuits 128 and other circuits process the measured voltage and convert the measured voltage to a digital value for further digital image processing.

When operating as an image sensing circuit as depicted in FIG. 5, the pixel performs a sampling operation to generate a signal corresponding to a level of light striking the photodiode 302 when the transfer gate transistor 308 is turned on and the photodiode 302 charges the capacitor 340 at a rate corresponding to the intensity of light that strikes the photodiode 302 during the sampling period (e.g. higher voltages and a higher charge rate for more intense light, and a lower voltage and charging rate for less intense light). When the capacitor 340 reaches a sufficient voltage level to turn on the buffer transistor 312 (e.g. 0.7 V or another suitable voltage level) then current flows through the buffer transistor 312 and the selector transistor 316 to charge the capacitor 124. The capacitor 124 is referred to as C_{LARGE} since the capacitor has sufficient size to store different charge levels across the full range of light intensity levels that the pixel detects during operation. The amount of time that the buffer transistor 312 remains switched on during the predetermined length of the sampling period determines the amount of time that the capacitor 124 accumulates charge. The final level of charge for the capacitor 124 at the end of the sampling period corresponds to the final output level for the pixel after the signal conditioning circuit 128 and other circuits such as analog to digital converters (ADCs) generate a digital output value for the pixel. After a sampling period, the reset transistor 304 drains the sensing capacitor 340, the transistor 120 drains the capacitor 124, and the pixel resets to detect light during a subsequent sampling period.

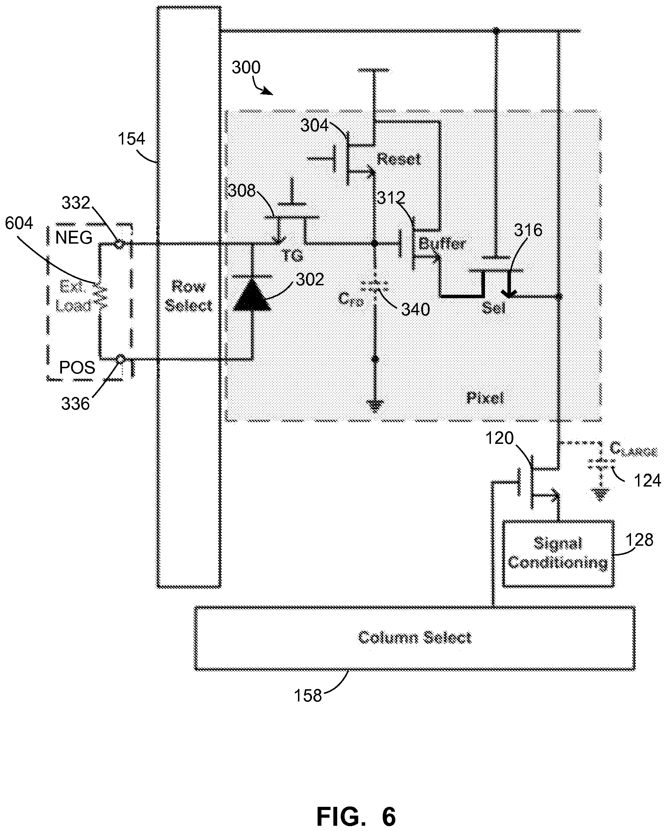

FIG. 6 depicts a configuration of the circuit 300 of FIG. 3 when the circuit 300 is configured to operate as a photovoltaic energy collector. In the configuration of FIG. 6, the positive terminal 336 and the negative terminal 332 are connected to an external load 604. In one configuration the load 604 is a charging circuit for a battery, super capacitor, or other energy storage device that provides power to different devices in a camera. In other configurations, the load 604 is one or more components in a camera that receive direct power from a CMOS energy collector. In the configuration of FIG. 6, the active components in the circuit 300, including the transistors 304, 308, 312, and 316, are all deactivated to enable the current from the photodiode 302 to flow to the load 604 and to reduce power consumption in the CMOS sensor when the pixel 300 is used for energy collection instead of image data generation.

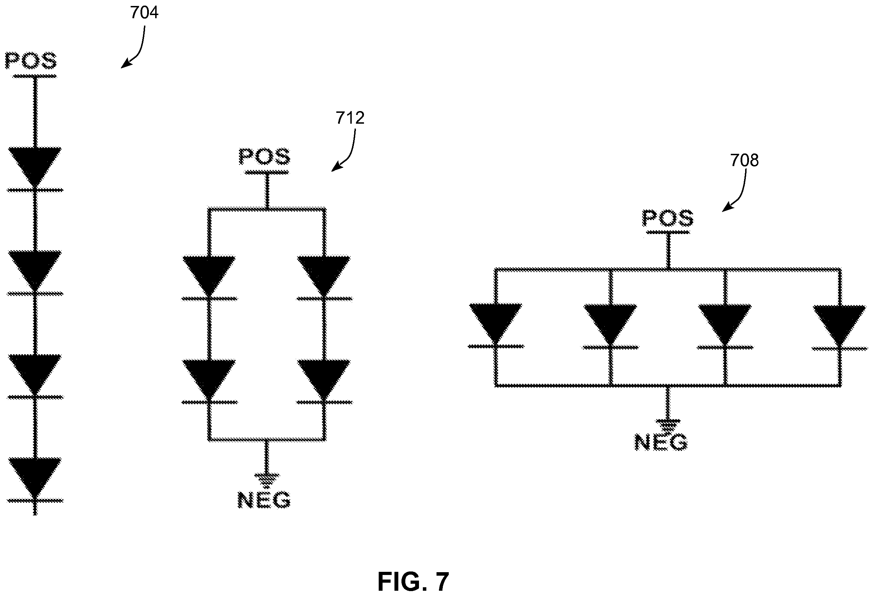

During an energy collection mode, a CMOS sensor often uses multiple pixels to collect energy since the total level of power that is delivered by a single pixel is typically smaller than the level of power output that is useful for charging batteries or powering other components in a camera. FIG. 7 depicts different configurations of multiple pixel circuits that are connected together during a power collection mode. In the configuration 704, the pixel circuits are connected in series to increase the total voltage level of the output. In the configuration 708, the pixels are connected in parallel to increase the total current level of the output. In the configuration 712, the pixels are connected together in groups of two or more series circuits and the series circuits are connected together in a larger parallel circuit to boost both the voltage level and current level of the output.

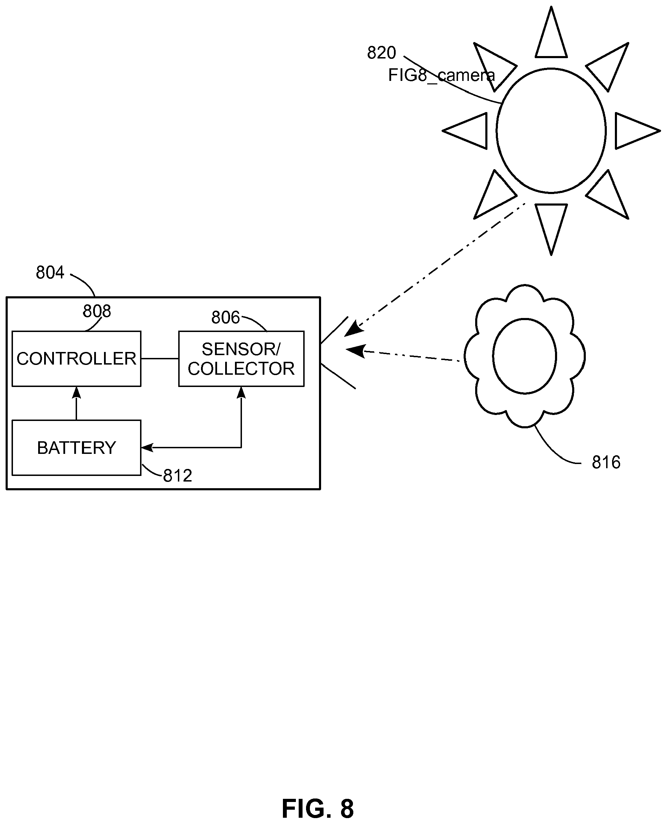

FIG. 8 depicts a camera 804 that incorporates a CMOS sensor with the pixel elements depicted in FIG. 3 and FIG. 4. The camera 804 includes the image sensor and photovoltaic power collector (sensor/collector) device 806, a controller 808, and a battery 812. The device 806 is a CMOS sensor that incorporates the pixel circuit 300 to enable pixels to operate in the image sensing mode of FIG. 5 or the energy collection mode of FIG. 6. The controller 808 is a control device that incorporates analog and digital control circuitry to operate the camera 804. In some embodiments, the controller 808 is implemented using CMOS digital logic circuits that are physically integrated with the semiconductor device 806. In other embodiments, the controller 808 is a discrete control device that is operatively connected to the device 806 via traces on a printed circuit board (PCB) or other suitable connection. The battery 812 provides electrical power to operate the controller 808, sensor 806, and other components in the camera 804 such as focusing devices, shutters, pan and tilt servos, and the like. The battery 812 is a rechargeable energy storage device such as a lithium-ion battery or other electrochemical cell. In some embodiments the battery 812 further comprises a super capacitor or other energy storage device.

During operation, the camera 804 generates digital images of an environment around the camera, such as the object 816 in FIG. 1. In the environment around the camera, one or more light sources 820 provide illumination for the object 816 and provide light that the sensor/collector 806 converts into electrical power to charge the battery 812 and provide power for components in the camera 804. One example of a suitable light source is 820 is the sun, but some artificial light sources also provide sufficient light energy to enable the device 806 to collect useful amounts of energy for operation of the camera 804. In some embodiments, a lens or mirrors in the camera 804 concentrates light from the light source 820 onto the surface of the sensor/collector 806, which enables the photovoltaic collector pixels in the sensor to generate higher levels of power compared to direct un-concentrated light from the same light source 820.

In some operating conditions, the light source 820 provides sufficient energy for the camera 804 to operate solely with the energy provided by the sensor/collector 806. In other operating modes, the sensor/collector 806 provides a portion of the required power while the battery 812 provides the balance of required power to operate the camera 804. The additional power from the sensor/collector 806 prolongs the effective life of the battery 812 between charging cycles and can be useful for cameras that are solely battery operated, or for reduction of energy consumption in cameras that may receive power from an electrical grid or other electrical power source. Because the individual pixels in the sensor/collector 806 can be operated in either an image sensing or energy collection mode, the camera 804 can generate images using all of the pixels in the device 806 in a sensing mode, collect energy using all of the photovoltaic energy collector pixels in the device 806 in an energy collection mode, or simultaneously generate images using some of the pixels and collect energy using other pixels in the device 806.

It will be appreciated that variants of the above-disclosed and other features and functions, or alternatives thereof, may be desirably combined into many other different systems, applications or methods.

## Claims

1. A pixel (300) in a complementary metal oxide semiconductor (CMOS) device (400) having a photodiode (302, 228) formed by PIN layer (228) and a first and second output terminal (332, 336) where neither terminal is connected to a fixed voltage supply comprising:
a) a substrate (202);
b) a first N-type region (N-; 434) formed in the substrate;
c) at least a portion of the photodiode (302; 228) formed in a portion of the substrate surrounded by the first N-type region (N-; 434) and isolated from a portion of the substrate outside the first N-type region (N-; 434), the photodiode having a cathode and an anode;
d) a second N-type region (N+; 438) formed in the portion of the substrate surrounded by the first N-type region (434), a first doping level of the first N-type region (N-; 434) being less than a second doping level of the second N-type region (N+; 438);
e) the first output terminal (332) connected to the second N-type region (N+; 438), the cathode of the photodiode (302) being connected to the first output terminal (332);
f) a first P-type region (432) formed in the portion of the substrate surrounded by the first N-type region (N-; 434);
g) the second output terminal (336) connected to the first P-type region (336), the anode of the photodiode (302) being connected to the second output terminal (332);
h) a first transistor (308) formed in the substrate (202) with a source connected to the first N-type region (N-; 434), a gate, and a drain (240);
i) the pixel (300) being configured to detect light striking the photodiode (302, 228) in response to the first terminal (332) being connected to a high-impedance, the second terminal (336) being connected to a ground, and the first transistor (308) being activated; and
j) the pixel (300) being configured to generate an electrical current to drive a load (604) through the first terminal (332) and second terminal (336) in response to light striking the photodiode (228, 302), a connection of the load (604) being to the first terminal (332) and the second terminal (336), and deactivation of the first transistor (308);
k) a second transistor (304) formed in the substrate with a source connected to the drain of the first transistor;
l) a third transistor (312) formed in the substrate with a gate connected to the drain of the first transistor and the source of the second transistor;
m) a fourth transistor (316) formed in the substrate with a drain connected to a source of the third transistor;
n) a fifth transistor (120) formed in the substrate with a drain connected to a source of the fourth transistor;
o) a capacitor (340) formed in the substrate with a first terminal connected to the drain of the first transistor, source of the second transistor, and gate of the third transistor, the capacitor configured to receive a charge from the photodiode in response to the first transistor being activated.

2. The pixel of claim 1 wherein the substrate is formed from a P-type material.

3. The pixel of claim 1 wherein the portion of the photodiode is a P-type material.

4. The pixel of claim 1, wherein the first terminal and the second terminal of the pixel are connected in series to corresponding terminals in a plurality of pixels formed in the substrate to connect a plurality of photodiodes in the plurality of pixels in series to provide the electrical current to the load.

5. The pixel of claim 1, wherein the first terminal and the second terminal of the pixel are connected in parallel to corresponding terminals in a plurality of pixels formed in the substrate to connect a plurality of photodiodes in the plurality of pixels in parallel to provide the electrical current to the load.

6. The pixel of claim 1, wherein the load is a battery (812) that receives a charging current from the pixel in response to the first terminal and the second terminal being connected to the load and the first transistor being deactivated.

7. A camera (804) comprising:
a) a complementary metal oxide semiconductor (CMOS) device (400) including a plurality of pixels (300) according to one or more of claims 1-6;
b) a battery (812) operatively connected to the CMOS device; and
c) a controller (808) operatively connected to the CMOS device, the controller being configured to:
c1) operate a first portion of the plurality of pixels in a first operating mode to generate an electrical current to charge the battery; and
c2) operate a second portion of the plurality of pixels in a second operating mode to generate image data corresponding to light that strikes the CMOS device simultaneously to operation of the first portion of the plurality of pixels in the first operating mode.

## Patentansprüche

1. Pixel (300) in einer Komplementärmetalloxidhalbleiter- (CMOS, Complementary Metal Oxide Semiconductor) Vorrichtung (400) mit einer Fotodiode (302, 228), die durch eine PIN-Schicht (228) gebildet ist, und einem ersten und zweiten Ausgangsanschluss (332, 336), wo keiner der Anschlüsse mit einer fixierten Spannungsversorgung verbunden ist, aufweisend:
a) eine Trägerschicht (202);
b) einen ersten N-Typ-Bereich (N-; 434), der in der Trägerschicht gebildet ist;
c) mindestens einen Abschnitt der Fotodiode (302; 228), der in einem Abschnitt der Trägerschicht gebildet ist, der vom ersten N-Typ-Bereich (N-; 434) umgeben ist und von einem Abschnitt der Trägerschicht außerhalb des ersten N-Typ-Bereichs (N-; 434) isoliert ist, wobei die Fotodiode eine Kathode und eine Anode hat;
d) einen zweiten N-Typ-Bereich (N+; 438), der im Abschnitt der Trägerschicht gebildet ist, der vom ersten N-Typ-Bereich (434) umgeben ist, wobei ein erster Dotierungsgrad des ersten N-Typ-Bereichs (N-; 434) weniger ist als ein zweiter Dotierungsgrad des zweiten N-Typ-Bereichs (N+; 438);
e) den ersten Ausgangsanschluss (332), der mit dem zweiten N-Typ-Bereich (N+; 438) verbunden ist, wobei die Kathode der Fotodiode (302) mit dem ersten Ausgangsanschluss (332) verbunden ist;
f) einen ersten P-Typ-Bereich (432), der im Abschnitt der Trägerschicht gebildet ist, der vom ersten N-Typ-Bereich (N-; 434) umgeben ist;
g) den zweiten Ausgangsanschluss (336), der mit dem ersten P-Typ-Bereich (336) verbunden ist, wobei die Anode der Fotodiode (302) mit dem zweiten Ausgangsanschluss (332) verbunden ist;
h) einen ersten Transistor (308), der in der Trägerschicht (202) gebildet ist, mit einer Source, die mit dem ersten N-Typ-Bereich (N-; 434) verbunden ist, einem Gate und einem Drain (240);
i) das Pixel (300), das konfiguriert ist, Licht, das auf die Fotodiode (302, 228) fällt, in Antwort darauf zu erfassen, dass der erste Anschluss (332) mit einer Hochimpedanz verbunden ist, der zweite Anschluss (336) mit einer Erdung verbunden ist und der erste Transistor (308) aktiviert ist; und
j) das Pixel (300), das konfiguriert ist, einen elektrischen Strom zu erzeugen, um eine Last (604) durch den ersten Anschluss (332) und zweiten Anschluss (336) zu erzeugen, in Antwort auf Licht, das auf die Fotodiode (228, 302) fällt, wobei eine Verbindung der Last (604) mit dem ersten Anschluss (332) und dem zweiten Anschluss (336) vorliegt, und der erste Transistor (308) deaktiviert ist;
k) einen zweiten Transistor (304), der in der Trägerschicht mit einer Source gebildet ist, die mit dem Drain des ersten Transistors verbunden ist;
l) einen dritten Transistor (312), der in der Trägerschicht gebildet ist, mit einem Gate, das mit dem Drain des ersten Transistors und der Source des zweiten Transistors verbunden ist;
m) einen vierten Transistor (316), der in der Trägerschicht gebildet ist, mit einem Drain, der mit einer Source des dritten Transistors verbunden ist;
n) einen fünften Transistor (120), der in der Trägerschicht gebildet ist, mit einem Drain, der mit einer Source des vierten Transistors verbunden ist;
o) einen Kondensator (340), der in der Trägerschicht gebildet ist, mit einem ersten Anschluss, der mit dem Drain des ersten Transistors, der Source des zweiten Transistors und dem Gate des dritten Transistors verbunden ist, wobei der Kondensator konfiguriert ist, eine Ladung von der Fotodiode in Antwort darauf zu empfangen, dass der erste Transistor aktiviert wird.

2. Pixel nach Anspruch 1, wobei die Trägerschicht aus einem P-Typ-Material gebildet ist.

3. Pixel nach Anspruch 1, wobei der Abschnitt der Fotodiode ein P-Typ-Material ist.

4. Pixel nach Anspruch 1, wobei der erste Anschluss und der zweite Anschluss des Pixels in Serie mit entsprechenden Anschlüssen in mehreren Pixeln verbunden sind, die in der Trägerschicht gebildet sind, um mehrere Fotodioden in den mehreren Pixeln in Serie zu verbinden, um den elektrischen Strom an die Last bereitzustellen.

5. Pixel nach Anspruch 1, wobei der erste Anschluss und der zweite Anschluss der Pixel parallel mit entsprechenden Anschlüssen in mehreren Pixeln verbunden sind, die in der Trägerschicht gebildet sind, um mehrere Fotodioden in den mehreren Pixeln parallel zu verbinden, um den elektrischen Strom an die Last bereitzustellen.

6. Pixel nach Anspruch 1, wobei die Last eine Batterie (812) ist, die einen Ladestrom von dem Pixel in Antwort darauf empfängt, dass der erste Anschluss und der zweite Anschluss mit der Last verbunden sind und der Transistor deaktiviert ist.

7. Kamera (804), aufweisend:
a) eine Komplementärmetalloxidhalbleiter- (CMOS) Vorrichtung (400), die mehrere Pixel (300) enthält, nach einem der Ansprüche 1-6;
b) eine Batterie (812), die betriebsbereit mit der CMOS-Vorrichtung verbunden ist; und
c) eine Steuerung (808), die betriebsbereit mit der CMOS-Vorrichtung verbunden ist, wobei die Steuerung konfiguriert ist zum:
c1) Betreiben eines ersten Abschnitts der mehreren Pixel in einem ersten Betriebsmodus, um einen elektrischen Strom zum Laden der Batterie zu erzeugen; und
c2) Betreiben eines zweiten Abschnitts der mehreren Pixel in einem zweiten Betriebsmodus, um Bilddaten entsprechend Licht zu erzeugen, das auf die CMOS-Vorrichtung fällt, gleichzeitig mit einem Betrieb des ersten Abschnitts der mehreren Pixel im ersten Betriebsmodus.

## Revendications

1. Pixel (300) dans un dispositif du type métal-oxyde-semi-conducteur complémentaires (CMOS) (400) comportant une photodiode (302, 228) formée par une couche PIN (228) et une première et une seconde bornes de sortie (332, 336) dans lesquelles aucune borne n'est connectée à une alimentation en tension fixe comprenant :
a) un substrat (202) ;
b) une première région de type N (N- ; 434) formée dans le substrat ;
c) au moins une partie de la photodiode (302 ; 228) formée dans une partie du substrat entourée par la première région de type N (N- ; 434) et isolée d'une partie du substrat à l'extérieur de la première région de type N (N- ; 434), la photodiode ayant une cathode et une anode ;
d) une seconde région de type N (N+ ; 438) formée dans la partie du substrat entourée par la première région de type N (434), un premier niveau de dopage de la première région de type N (N- ; 434) étant inférieur à un second niveau de dopage de la seconde région de type N (N+ ; 438) ;
e) la première borne de sortie (332) connectée à la seconde région de type N (N+ ; 438), la cathode de la photodiode (302) étant connectée à la première borne de sortie (332) ;
f) une première région de type P (432) formée dans la partie du substrat entourée par la première région de type N (N- ; 434) ;
g) la seconde borne de sortie (336) connectée à la première région de type P (336), l'anode de la photodiode (302) étant connectée à la seconde borne de sortie (332) ;
h) un premier transistor (308) formé dans le substrat (202) avec une source connectée à la première région de type N (N- ; 434), une grille et un drain (240) ;
i) le pixel (300) étant configuré pour détecter la lumière frappant la photodiode (302, 228) en réponse à la connexion de la première borne (332) à une haute impédance, à la connexion de la seconde borne (336) à une masse, et à l'activation du premier transistor (308) ; et
j) le pixel (300) étant configuré pour générer un courant électrique afin d'entraîner une charge (604) à travers la première borne (332) et la seconde borne (336) en réponse au fait que la lumière frappe la photodiode (228, 302), qu'une connexion de la charge (604) est reliée à la première borne (332) et à la seconde borne (336) et à la désactivation du premier transistor (308) ;
k) un deuxième transistor (304) formé dans le substrat avec une source connectée au drain du premier transistor ;
l) un troisième transistor (312) formé dans le substrat avec une grille connectée au drain du premier transistor et à la source du deuxième transistor ;
m) un quatrième transistor (316) formé dans le substrat avec un drain connecté à une source du troisième transistor ;
n) un cinquième transistor (120) formé dans le substrat avec un drain connecté à une source du quatrième transistor ;
o) un condensateur (340) formé dans le substrat avec une première borne connectée au drain du premier transistor, à la source du deuxième transistor et à la grille du troisième transistor, le condensateur étant configuré pour recevoir une charge de la photodiode en réponse à l'activation du premier transistor.

2. Pixel selon la revendication 1, dans lequel le substrat est formé à partir d'un matériau de type P.

3. Pixel selon la revendication 1, dans lequel la partie de la photodiode est formée par un matériau de type P.

4. Pixel selon la revendication 1, dans lequel la première borne et la seconde borne du pixel sont connectées en série à des bornes correspondantes dans une pluralité de pixels formés dans le substrat pour connecter une pluralité de photodiodes dans la pluralité de pixels en série afin de fournir le courant électrique à la charge.

5. Pixel selon la revendication 1, dans lequel la première borne et la seconde borne du pixel sont connectées en parallèle à des bornes correspondantes dans une pluralité de pixels formés dans le substrat pour connecter une pluralité de photodiodes dans la pluralité de pixels en parallèle afin de fournir le courant électrique à la charge.

6. Pixel selon la revendication 1, dans lequel la charge est une batterie (812) qui reçoit un courant de charge du pixel en réponse à la connexion de la première borne et de la seconde borne à la charge et à la désactivation du premier transistor.

7. Caméra (804) comprenant :
a) un dispositif métal-oxyde-semi-conducteur complémentaires (CMOS) (400) comprenant une pluralité de pixels (300) selon l'une ou plusieurs des revendications 1 à 6 ;
b) une batterie (812) connectée de manière opérationnelle au dispositif CMOS ; et
c) un dispositif de contrôle (808) connecté de manière opérationnelle au dispositif CMOS, le dispositif de contrôle étant configuré pour :
c1) faire fonctionner une première partie de la pluralité de pixels selon un premier mode de fonctionnement afin de générer un courant électrique pour charger la batterie ; et
c2) faire fonctionner une seconde partie de la pluralité de pixels selon un second mode de fonctionnement afin de générer des données d'image correspondant à la lumière qui frappe le dispositif CMOS simultanément au fonctionnement de la première partie de la pluralité de pixels selon le premier mode de fonctionnement.
